(19) **Europäisches Patentamt** / **European Patent Office** / **Office européen des brevets**

(11) **EP 2 509 204 B1**

(12) **EUROPEAN PATENT SPECIFICATION**

(45) Date of publication and mention of the grant of the patent:
**21.03.2018 Bulletin 2018/12**

(51) Int Cl.:
***H02M 3/28*** *(2006.01)*

(21) Application number: **11190273.0**

(22) Date of filing: **23.11.2011**

(54) **Power supply**

Netzteil

Alimentation

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.11.2010 FI 20106251**

(43) Date of publication of application:
**10.10.2012 Bulletin 2012/41**

(73) Proprietor: **Balluff GmbH**
**73765 Neuhausen (DE)**

(72) Inventors:
• **Varpa, Seppo**
**18300 Heinola (FI)**
• **Varpa, Vesa**
**04410 Järvenpää (FI)**
• **Lehto, Ismo**
**17200 Vääksy (FI)**

(74) Representative: **Jakelski & Althoff**
**Patentanwälte PartG mbB**
**Patentanwälte**
**Partnerschaftsgesellschaft**
**Mollenbachstraße 37**
**71229 Leonberg (DE)**

(56) References cited:
JP-A- 2009 195 044    US-A1- 2007 150 236
US-A1- 2009 072 982    US-B2- 6 880 967

EP 2 509 204 B1

## Description

### Field of the Invention

The invention relates generally to a power supply and particularly to a power supply with condition indicators for indicating parameters concerning operating conditions and/or remaining lifetime of the power supply.

### Background of the Invention

Lifetime of industrial power supplies is primarily limited by aging-related failure of electrolytic capacitors. The most significant factor affecting aging of electrolytic capacitors is temperature. For instance, reference [1] discloses that the lifetime of the electrolytic capacitor can be calculated by the following arithmetic expression based on a law known as the Arrhenius law.

$$L_x = L_0 \cdot 2^{(T_0 - t_x)/10} \cdot k \qquad\qquad [\,1\,]$$

The calculation uses the following parameters:

$L_x$: lifetime estimate at the time of actual use (time)
$L_0$: warranty lifetime (time) at a maximum using temperature
$T_0$: maximum using temperature (°C)
$t_x$: actual using temperature (°C)
k: lifetime coefficient.

Various equations for the lifetime coefficient k are proposed by capacitor makers, and the coefficient is a conversion coefficient obtained from applied voltage, ripple current, ambient temperature or the like. As an illustrative but non-restrictive example, a reference is made to reference [3]. As disclosed in reference [1], the temperature $T_0$ of the electrolytic capacitor expected under a standard using conditions, for example, is first determined, and an initial total remaining lifetime $L_0$ of the given temperature $T_0$ is calculated using the above Arrhenius equation.

When the actual use of the power supply is started, whenever a constant time a, is elapsed, a remaining lifetime at the given temperature $T_0$ may be calculated from a derivative of the Arrhenius law:

$$L_n = L_{n-1} - a \cdot 2^{(t_x - t_0)/10} \cdot k \qquad\qquad [\,2\,]$$

Herein $n$=1, 2, 3 ..., and $t_x$ is an average temperature detected by a temperature sensor at the predetermined constant time a. The remaining lifetime $L_0$, which is calculated whenever the constant time a is elapsed, becomes smaller than the previously calculated remaining lifetime $L_{n-1}$, and the remaining lifetime is gradually reduced.

In addition, reference [2] discloses that the equivalent series resistance (ESR) of electrolytic capacitors increases with aging, and this increase can be measured by observing the AC ripple voltage over the capacitor.

It is thus known in the art to provide a power supply with lifetime-estimating means and indicator means that indicate an estimate for the remaining lifetime of the power supply by monitoring temperature or equivalent series resistance of an electrolytic capacitor.

JP 2009 195044 A discloses a power supply comprising a power stage, a monitoring stage and a user interface, wherein the power stage comprises: a primary side with a primary electrolytic capacitor, a secondary side with a secondary electrolytic capacitor, a galvanic isolation element arranged to provide galvanic isolation between the primary side and the secondary side, a rectifier stage arranged to provide rectified electric energy from the galvanic isolation element to the secondary electrolytic capacitor; a temperature sensor arranged to sense temperatures of the primary electrolytic capacitor; a current sensing element arranged to sense an output current from the secondary side, logic means arranged to perform a set of predetermined calculations, such that the set of predetermined calculations yield a lifetime estimate and a current load level estimate for the power supply, wherein the logic means further comprises an operating statistics memory for storing history data based on results of the predetermined calculations, presentation means for converting the lifetime estimate and current load level estimate to respective formats presentable via the user interface, and wherein the user interface comprises indicator means, responsive to the presentation means, for presenting an indication of the lifetime estimate.

Other relevant background art is disclosed in US 6 880 967 B2, US 2009/072982 A1 and "Aluminum Electrolytic Capacitors, Precautions and Guidelines" publication CAT. No E1001H, Nippon Chemi-Con.

Some problems remain, however. For instance, the prior art fails to account for intermittent usage of the power supply. The estimation for the remaining lifetime may be based on the assumption that the power supply is in continuous operation, whereas in actual fact the power supply may be powered on only during office hours, for example. Furthermore, the lifetime-estimation techniques disclosed in the above-identified prior art are based on the assumption that the rate of aging of electrolytic capacitors increases progressively and predictably in response to increase temperature, but the identified prior art is silent regarding high-risk conditions in which failure is not predictable with any precision. Such high-risk conditions are characterized by one or more of the following conditions: spurious primary-side overvoltage spikes, frequent overload conditions, abnormally high operating temperatures even if they are short in duration. Furthermore, while the prior art discloses techniques for estimating the remaining lifetime of a power supply, the prior art is silent as regards measuring the rate at which the electrolytic capacitors age. This means that a conventional lifetime estimate lacks an early-warning system, and abnormal conditions are only observed by detecting that, say, a power supply's lifetime estimate has dropped by three years during the past 12 months. Finally, a residual problem not addressed by the prior art documents is the problem of monitoring parameters of the primary-side electrolytic capacitor(s) when the monitoring circuitry resides in the potential of the secondary side.

**Summary of the Invention**

It is an object of the present invention to alleviate one or more of the above-identified problems. This object is achieved by a power supply according to claim 1. The dependent claims as well as the following detailed description and drawings relate to specific embodiments which provide additional benefits and/or solve additional problems.

An aspect of the invention is a power supply, which comprises a power stage, a monitoring stage and a user interface. The power stage comprises a primary side with a primary electrolytic capacitor; a secondary side with a secondary electrolytic capacitor; a galvanic isolation element arranged to provide galvanic isolation between the primary side and the secondary side; and a rectifier stage arranged to provide rectified electric energy from the galvanic isolation element to the secondary electrolytic capacitor. These are well-known elements of virtually any power supply.

In order to provide temperature-related sensory functions, the power supply comprises a primary temperature sensor and a secondary temperature sensor respectively arranged to sense temperatures of the primary electrolytic capacitor and the secondary electrolytic capacitor.

In order to provide voltage- and current-related sensory functions, the power supply comprises a voltage sensor arranged to sense an input voltage present at the primary side and a current sensing element arranged to sense an output current from the secondary side.

The monitoring stage comprises A/D conversion means arranged to receive information from each of the primary temperature sensor, secondary temperature sensor, the voltage sensor and the current sensing element; logic means arranged to perform a set of predetermined calculations on the information received by the A/D conversion means, such that the set of predetermined calculations yield a lifetime estimate, an aging rate estimate and a current load level estimate for the power supply, wherein the logic means further comprises an operating statistics memory for storing history data based on results of the predetermined calculations; and presentation means for converting the lifetime estimate, aging rate estimate and current load level estimate to respective formats presentable via the user interface.

The user interface comprises indicator means, responsive to the presentation means, for presenting a first indication of the aging rate estimate, a second indication of the lifetime estimate, and third indication of the load level estimate.

The indicator means are preferably visual indicators, such as LEDs or LCD devices, which provide a simultaneous indication of the remaining lifetime estimate; the aging rate estimate, which is a derivative of the remaining lifetime estimate; and the load level estimate, which indicates risks related to immediate overload-related failures.

The indicator for the remaining lifetime estimate is preferably a steady-state indicator, in the sense that the indication does not change periodically. A LED or LCD bar graph, in which the proportion of "safe" colour, such as white or green, may indicate remaining lifetime, while a "risky" colour, such as black or red, indicates lifetime already utilized. Such a LED or LCD bar graph may be used for the aging rate indicator and/or the load level indicator as well, wherein a progressively increasing portion of "risky" colour indicates an increasing aging rate or load level, respectively. Alternatively or additionally, the increasing aging rate or load level may be indicated by a progressively increasing blinking rate.

A benefit of the simultaneous indication of the remaining lifetime estimate, aging rate estimate and load level estimate provides the benefit that assessment of the condition of the power supply may be performed very rapidly, merely by inspecting it visually.

Some embodiments of the invention relate to techniques for obtaining an accurate indication of the internal temperature of the electrolytic capacitors, as will be described later in more detail.

## Brief Description of the Drawings

Specific embodiments of the present invention will be described in detail, in connection with the attached drawings in which like reference signs denote like items and:

Figure 1 is a schematic block diagram of a power supply according to an embodiment of the present invention;
Figure 2 shows a representative display portion of a built-in user interface of the power supply;
Figure 3 shows an optional remote controller which may be used to provide more extensive user interface functionality than the built-in user interface; and
Figures 4A and 4B depict arrangements for sensing the temperature of electrolytic capacitors;

## Detailed Description of Specific Embodiments

In the drawings, which depict specific illustrative but non-restrictive embodiments of the invention, the first digit of a reference numeral generally indicates the drawing in which the item is first introduced. Like reference numerals denote like items and a repetitive description is usually omitted.

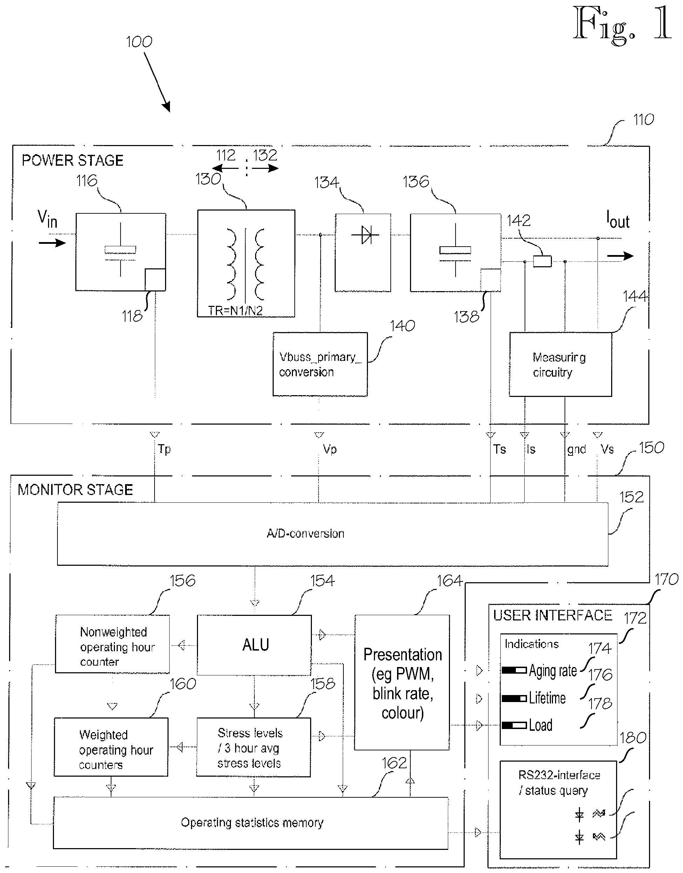

Figure 1 is a schematic block diagram of a power supply 100 according to an embodiment of the present invention. The power supply 100 comprises three major sections, namely a power stage 110, a monitoring stage 150 and a user interface 170. The power stage 110 comprises a primary side 112 and secondary side 132, which are galvanically isolated from each other by means of a galvanic isolation element 130. In the present embodiment, wherein the primary side is operable for connection into a DC bus voltage Vin, the galvanic isolation is provided by a transformer 130, the primary winding of which is coupled to the DC input voltage Vin via a switching element that converts the DC bus voltage to a square wave. The DC bus voltage may be obtained directly from a DC input source, or it may be produced by rectifying an AC input source. A primary-side electrolytic capacitor 116 averages the load presented on the input voltage by the power supply. The secondary winding of the transformer 130 feeds the secondary side 132 of the power supply, via a rectifier stage 134 and a secondary-side electrolytic capacitor 136.

In addition, the power supply 100 comprises means for voltage regulation and instant overload protection. Such regulation and protection means are well known in the art, however, and a detailed description is omitted for the sake clarity and brevity.

Electrolytic capacitor, such as those indicated by reference numerals 116 and 136, are currently the only type of capacitors capable of handling the required currents, which are sufficiently compact and economical for large-scale commercial production. The electrolytic capacitors also constitute the primary fault mechanism of the power supply. This means that an estimate for the remaining lifetime of the electrolytic capacitors serves as a reasonably good estimate for the remaining lifetime of the entire power supply. In a manufacturing plant, for example, it is quite possible that a malfunctioning power supply stops an entire production line. Such production gaps can be minimized by monitoring the lifetime estimate of the power supplies and by proactively replacing power supplies before they cease to operate.

Such lifetime-estimation functionality is provided by the monitoring stage, denoted by reference numeral 150. The monitoring stage 150 is configured to monitor a number of sensing elements provide in the power stage 110. The sensing elements include a primary temperature sensor 118 and a secondary temperature sensor 138. These are respectively arranged to sense temperatures of the primary electrolytic capacitor 116 and the secondary electrolytic capacitor 136. The sensing elements monitored by the monitoring stage 150 also include a voltage sensor 140 arranged to sense an input voltage present at the primary side, as well as a current sensing element 142, 144 arranged to sense an output current from the secondary side. In the present embodiment, the current sensing element is implemented as a current shunt 142 and measuring circuitry 144.

In the monitoring stage 150, output signals from the primary and secondary temperature sensor 118, 138, as well as output signals from the voltage sensor 140 and current sensing element 142, 144, are applied to A/D (analogue-to-digital) conversion means 152. The monitoring stage 150 also comprises logic means, denoted by reference numerals 154 to 162, which are configured to perform a set of predetermined calculations on the various information streams received by the A/D conversion means 152. The set of predetermined calculations yield a lifetime estimate, an aging rate (stress) estimate and a current load level estimate for the power supply 100. For the purposes of keeping track of the remaining lifetime estimate, aging rate means the derivative of the remaining lifetime estimate (or, actually, its negative). For the purposes of indicating the aging rate to human users, it may be convenient to use a normalized value, in which a continuously maintained aging rate of 1 means that, statistically, the specified lifetime of the power supply will be achieved, and an aging rate of 3, maintained over 12 hours, reduces the remaining lifetime estimate by 3*12=36 hours. In contrast, the load indication, denoted by reference numeral 178, is not directly coupled to temperature-related predictable lifetime degradation but to short term load monitoring, and the load indication is a predictor of short-term risk for immediate protection action of the power supply to prevent overload-related failure. Such protection action can be accomplished by lowering current limitation on the output side, which causes a decrease in output voltage.

The calculations performed by the logic means are exemplified by an arithmetic-logic unit (ALU) 154, a non-weighted operating hour counter 156, a stress level calculator 158 and a set of weighted operating hour counters 160. In one illustrative example, the ALU 154 is configured to monitor operating hours, that is, hours that the power supply is powered on. The operating hours are tallied by the non-weighted operating hour counter 156, which keeps track of actual power-on hours. The ALU 154 is also configured to utilize a current stress level calculator, which is denoted by reference numeral 158. The current stress level may be averaged over some period of appropriate length, such as a few hours.

Outputs from the non-weighted operating hour counter 156 and stress level calculator 158 are combined in weighted operating hour counters, denoted by reference numeral 160. After each computational period, such as a few hours, the current lifetime estimate of the power supply is reduced by the weighted operating hours tallied by the weighted operating hour counters 160.

The mutual operation of the blocks 154 to 162 may be as follows. The current lifetime estimate for the power supply is stored in the memory 162. When the power supply is manufactured, an initial lifetime estimate is stored in the memory 162, and this serves as an initial value for the current lifetime estimate. The current lifetime estimate is reduced, based on actual operating hours, as tallied by the operating hour counter 156, and a stress level, as indicated by the stress level calculator 158. Specifically, low stress levels which do not affect the lifetime of the power supply are assigned a weight factor of 1 and higher stress levels which result in a reduced lifetime are assigned a proportionally higher weight factor. A stress level which, statistically, causes a 1:N reduction in the lifetime of the power supply, if maintained continuously, is assigned a weight factor of N.

In the illustrated example, the ALU 154 monitors output signals from the power stage 110, via the various sensors 118 and 138 - 144, and via the A/D conversion 152. Based on this information, the ALU 154 utilizes the stress level calculator 158, which calculates a weight factor for the stress level for the power supply 100, such that a weight factor of N indicates that if the stress level is maintained continuously, the lifetime of the power supply experiences an N-fold reduction compared with its nominal lifetime, which may be 15 years, for example. If a stress level with a weight factor of three is maintained for two years, the lifetime estimate of the power supply will be reduced by 3*2=6 years, and so on.

Presentation of the various calculations as distinct functional blocks 154 - 158 is intended to illustrate rather than restrict the invention, and many alternative implementations are possible. In a typical implementation, the ALU 154 is implemented as a programmed industrial microprocessor. The stress level calculator 158 may be implemented as a computational routine that monitors the temperature, voltage and current information (118, 138, 140, 142-144) from the power stage 110, calculates a current stress level and averages the calculated stress level over some appropriate period, such as a few hours or 24 hours. In an analogous manner, the weighted operating hour counters 160 may be implemented as a computational routine whose inputs include actual operating hours over a monitoring period, as indicated by counter 156, and the averaged stress-level-based weight factor over that monitoring period, as indicated by the stress level calculator 158. The actual operating hours over the monitoring period and the weight factor over the same monitoring period are combined, such as multiplied, by the weighted operating hour counters 160, which are again implemented as computational routines configured to reduce the current lifetime estimate stored in the memory 162.

The legends for the blocks 158 and 160 are in plural form. This means that the stress level and current lifetime estimate may be calculated for either electrolytic capacitor separately, and the minimum of the current lifetime estimates for the two electrolytic capacitors will be used as the current lifetime estimate for the entire power supply.

For example, the stress level for the secondary electrolytic capacitor may be calculated along the following guidelines:

First, an RMS value for the output current is calculated:

$$I_{OUT\_RMS} = \sqrt{(I_1^2 + I_2^2 + \ldots I_n^2)/n} \qquad [3]$$

Herein $I_1$ through $I_n$ are n temporary samples of the output current. The n temporary samples are averaged to obtain a DC current value:

$$I_{OUT\_DC} = (I_1 + I_2 + \ldots I_n)/n \qquad [4]$$

Next, the AC component of the output current is calculated by subtracting normalized DC output power from the normalized RMS power and taking a square root from the difference:

$$I_{OUT\_AC} = \sqrt{I_{OUT\_RMS}^2 - I_{OUT\_DC}^2} \qquad\qquad [5]$$

Finally, the AC component of the output current may be combined with the ripple current:

$$I_{RIPPLE\_TOTAL} = \sqrt{I_{OUT\_AC}^2 + I_{RIPPLE}^2} \qquad\qquad [6]$$

Herein, $I_{RIPPLE}$ is the ripple current of the secondary-side electrolytic capacitor in a load situation observed by the measurement circuitry. $I_{RIPPLE}$ may be calculated from functions observed from curve-fitting of measurements which characterize the power supply. $I_{RIPPLE\_TOTAL}$ is the RMS sum of the internal and external ripple currents and is the current that warms up the electrolytic capacitor.

The stress level of the electrolytic capacitors is also influenced by temperature. It is well known in the art to calculate the influence of temperature by means of the Arrhenius rule. The combined stress of temperature and ripple current may be calculated from formulas published by manufacturers of electrolytic capacitors. As an illustrative but non-restrictive example, a reference is made to reference [3].

The monitoring stage 150 also comprises presentation means 164 for converting the current lifetime estimate, aging rate estimate and current stress level estimate to respective formats which are presentable by the user interface 170. In an illustrative but non-restrictive implementation example, the user interface 170 comprises several indicators, generally denoted by reference numeral 172, which are responsive to output signals from the presentation means 164. The set of indicators 172 comprises a first indication 174 of the aging rate estimate, a second indication 176 of the current lifetime estimate and third indication 178 of the load level estimate. The second indication 176 of the current lifetime estimate may be based on the stored history of average use.

In a particularly effective implementation, the indication 174 of the aging rate estimate is formatted as follows. The physical indicator is a blinking light source, such as a LED (Light-Emitting Diode), and the aging rate is indicated by varying the blinking rate of the LED. Normal aging, ie, an aging rate consistent with the nominal lifetime of the power supply, is indicated by a blinking rate that approximately matches the pulse of a very relaxed person, such as 30 - 70 pulses per minute. As the aging rate increases, the blinking rate is increased proportionally, either continuously or in a step-wise manner such that there are n predefined blinking rates, each of which indicates a respective range of aging rates.

In addition, it is beneficial to vary the colour of the aging rate indicator. For instance, normal aging rate may be indicated by green colour, a level of increased aging rate is indicated by yellow colour and a still higher level of increased aging rate is indicated by red colour.

As regards the second indication 176 of the current lifetime estimate, a particularly advantageous form of indication is a LED bar. In one implementation, the length of the illuminated LED bar indicates the remaining lifetime of the power supply. For instance, a 10-unit LED bar may be used to indicate the remaining lifetime such that 10 illuminated LEDs indicates a lifetime estimate of 10 or more years, and n illuminated LEDs, wherein n <10, indicates a lifetime estimate of n years. In addition, changing the LED colour first from green to yellow and then from yellow to red may indicate that the lifetime estimate has dropped below two predefined thresholds.

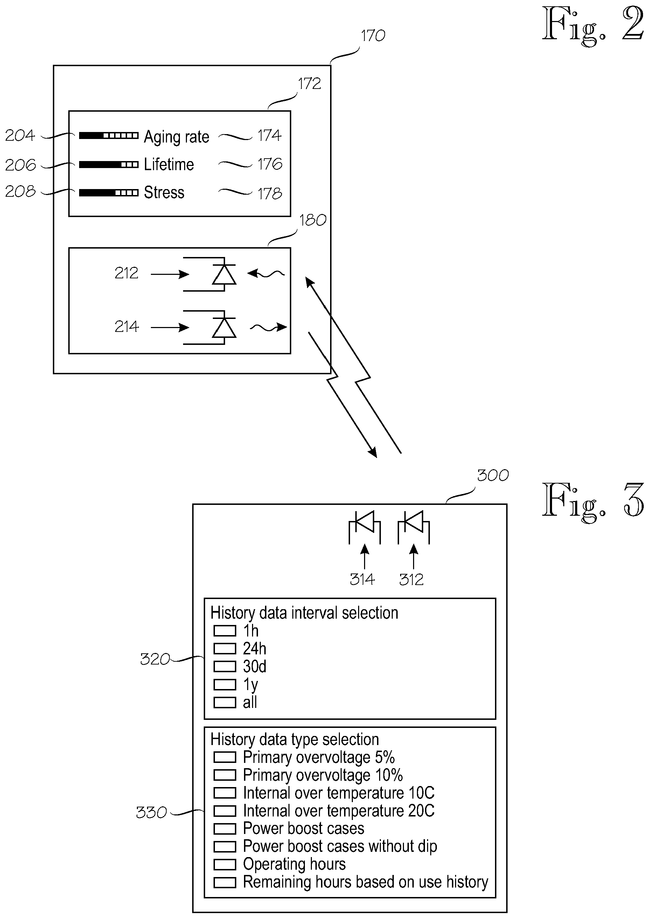

Figure 2 shows a representative display portion 172 of a built-in user interface 170 of the power supply, while Figure 3 shows an optional remote controller which may be used to provide more extensive user interface functionality than the built-in user interface. As shown in Figure 2, the aging rate (stress level) indicator 174, remaining lifetime indicator 176 and load level indicator 178 may be implemented as dual-colour or multiple-colour bar indicators, 204, 206 and 208, respectively. In order to facilitate human assessment of the condition of the power supply, it is beneficial to assign a "safe" colour, such as white or green, to a low aging rate, low load level or long remaining lifetime, whereas a "high-risk" colour, such as black or red, is assigned to a high aging rate, high load level or short remaining lifetime.

The built-in user interface 170 of the power supply may comprise a two-way communication circuitry for communicating with an optional remote control device, shown as item 300 in Figure 3. The remote controller 300 may be implemented as a controller dedicated for the inventive power supply, or it may be a general-purpose remote controller adapted or configured for the purpose of communicating with the inventive power supply. For instance, remote controllers of the type commonly used with home theatre systems may be used for this purpose. In Figures 2 and 3, the two-way communication circuitry has been implemented as light-emitting and light-sensitive diodes, such that light-sensitive diode 212 receives transmission from light-emitting diode 312 of the remote controller, while diodes 214, 314 send information from the built-in user interface 170 to the remote controller 300. Alternatively, a smart telephone or a keypad computer may be used as the remote controller, and the optical communication described earlier may be replaced by a short-range radio interface, including but not limited to Bluetooth or WLAN, for example.

The optional remote controller 300 may comprise user interface elements, such as pushbuttons or touch-sensitive areas 320, 330, for selecting a history data interval selection or a history data type selection. For instance, the user may instruct the remote controller 300 to retrieve from the power supply (specifically, from the operating statistics memory 162) data for primary-side overvoltage, internal over temperature, power boost cases with or without voltage dip, past operating hours and an estimate for the remaining lifetime based on the history of prior use.

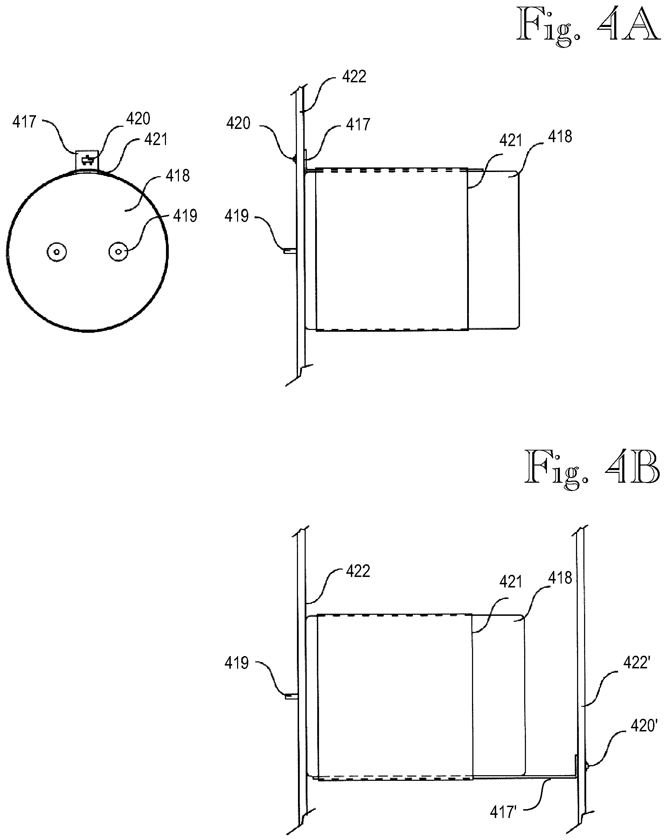

Figures 4A and 4B depict arrangements for sensing the temperature of electrolytic capacitors. In the embodiment shown in Figure 4A, an electrolytic capacitor 418 is mounted on a printed circuit board 422. Reference numerals 419 depict the normal electrodes (connection pins) of the capacitor. According to an embodiment of the invention, a slice 417 of a good thermal conductor material, such as metal, is thermally coupled to the electrolytic capacitor 418. In the present embodiment, the thermal coupling is provided by a sleeve 421 which surrounds the electrolytic capacitor 418 and the thermal conductor slice 417 for a significant portion of their lengths, while at least partially insulating the slice 417 from the ambient temperature. The effect of this thermal coupling is that the thermal conductor slice 417 attains a temperature which corresponds to the surface temperature of the electrolytic capacitor 418. The thermal conductor slice 417 may be mounted on the printed circuit board 422 by gluing or soldering, for example. This type of mounting performs two simultaneous functions. Firstly, the mounting provides a secure mounting for the electrolytic capacitor itself. Secondly, the mounting conveys the surface temperature of the electrolytic capacitor 418 to the portion of the printed circuit board 422, on which the slice is mounted. On the side of the printed circuit board 422 opposite to the electrolytic capacitor 418 and the thermal conductor slice 417, a temperature sensor 420 is mounted. Because the temperature sensor 420 is mounted on the side of the printed circuit board 422, which is opposite to the electrolytic capacitor 418 and the thermal conductor slice 417, the temperature sensor 420 has a very good electric isolation from the connection pins and the shell of the electrolytic capacitor 418. This is particularly important on the primary side, where high voltage levels or spikes may be present. As shown on the end view of Figure 4A, the thermal conductor slice 417 and the temperature sensor 420 are optimally mounted at a place of the rim of the electrolytic capacitor 418 which is equidistant from the connection pins 419, because this place has the largest minimum distance to the connection pins 419, on which high voltage levels or spikes may occur.

Figure 4B shows an alternative implementation, in which only the electrical connection pins 419 of the electrolytic capacitor 418 are mounted on the first printed circuit board 422, and the temperature sensor, denoted here by reference numeral 420' is mounted on second printed circuit board 422', a portion of which, opposite to the temperature sensor 420', is coupled to the surface temperature of the electrolytic capacitor 418 by a thermal conductor slice 417'.

At best, the temperature sensors 420, 420' described in connection with Figures 4A and 4B, are able to sense the surface temperature of the electrolytic capacitor 418. As far as calculation of remaining lifetime and aging rate is concerned, what matters is the internal temperature of the electrolytic capacitor.

According to an embodiment of the present invention, an internal "hot spot" temperature of one or more electrolytic capacitors is computed, given the measured value of the primary voltage and the output current. This hot spot temperature of the electrolytic capacitor is typically higher than the surface temperature. Therefore the hot spot temperature is also a better predictor of the remaining lifetime of the capacitor. The ripple (AC) component of the load current contributes heavily to the difference between the surface temperature and the hot spot temperature. The ripple current can be calculated as shown by equations 3 through 6.

Formulas for converting surface temperature to the internal hot spot temperature, given the ripple current of the electrolytic capacitor, can be obtained from manufacturers of the capacitors. As an illustrative but non-restrictive example, a reference is made to reference [3]. Such formulas can be taken into account by the stress level calculator 158 and weighted operating hours counter 160 (see Figure 1).

The electrolytic capacitor 418 shown in Figures 4A and 4B corresponds to either or both of the primary-side capacitor 116 and secondary-side capacitor 136 shown in Figure 1. Similarly, the temperature sensors 420, 420' shown in Figures 4A and 4B correspond to either or both of the sensors 118, 138 shown in Figure 1.

The above description of the specific embodiments is illustrative rather than restrictive. It is apparent to those skilled in the art that with advancing technology, the invention can be implemented in various embodiments. Accordingly, the scope of protection is defined by the following claims.

**Claims**

1. A power supply (100) comprising a power stage (110), a monitoring stage (150) and a user interface (170); wherein the power stage (110) comprises:

   - a primary side (112) with a primary electrolytic capacitor (116);
   - a secondary side (132) with a secondary electrolytic capacitor (136);
   - a galvanic isolation element (130) arranged to provide galvanic isolation between the primary side (112) and the secondary side (132);

- a rectifier stage (134) arranged to provide rectified electric energy from the galvanic isolation element (130) to the secondary electrolytic capacitor (136);
- a primary temperature sensor (118) and a secondary temperature sensor (138) respectively arranged to sense temperatures of the primary electrolytic capacitor (116) and the secondary electrolytic capacitor (136);
- a voltage sensor (140) arranged to sense an input voltage present at the primary side;
- a current sensing element (142, 144) arranged to sense an output current from the secondary side;
- wherein the monitoring stage (150) comprises:
- A/D conversion means (152) arranged to receive information from each of the primary temperature sensor (118), secondary temperature sensor (138), the voltage sensor (140) and the current sensing element (142,144);
- logic means (154-162) arranged to perform a set of predetermined calculations on the information received by the A/D conversion means (152), such that the set of predetermined calculations yield a lifetime estimate, an aging rate estimate and a current load level estimate for the power supply (100), wherein the logic means further comprises an operating statistics memory (162) for storing history data based on results of the predetermined calculations;
- presentation means (164) for converting the lifetime estimate, aging rate estimate and current load level estimate to respective formats presentable via the user interface (170);
- and wherein the user interface (170) comprises:
- indicator means (172), responsive to the presentation means (164), for presenting a first indication (174) of the aging rate estimate, a second indication (176) of the lifetime estimate, and third indication (178) of the load level estimate.

2. A power supply (100) according to claim 1, wherein the logic means (154-162) comprises:

- means for storing a current value of the lifetime estimate;
- means for reducing the current value of the lifetime estimate based on the information from the primary temperature sensor (118), secondary temperature sensor (138), the voltage sensor (140) and the current sensing element (142,144);
- means for updating the stored current value of the lifetime estimate based on the reduced current value of the lifetime estimate.

3. A power supply (100) according to claim 1, wherein the first indication (174) of the aging rate estimate is a visual indication and the format for the aging rate estimate, as provided by the presentation means (164), comprises a blinking rate, which is continuously or step-wise proportional to the aging rate estimate.

4. A power supply (100) according to claim 3, wherein the format for the aging rate estimate, as provided by the presentation means (164), further comprises at least one colour change when the aging rate estimate passes a predetermined threshold.

5. A power supply according to any one of the preceding claims, wherein:

- at least one temperature sensor (118, 138, 420, 420') is mounted on a printed circuit board (420, 420'), on the side opposite to its respective electrolytic capacitor (418), and the area of the circuit board immediately opposite to the temperature sensor is thermally coupled to a surface temperature of the electrolytic capacitor by a thermal conduction element; and
- the power supply comprises means for converting the temperature sensed via the temperature sensor to an internal temperature of the electrolytic capacitor.

**Patentansprüche**

1. Stromversorgung (100), umfassend eine Leistungsstufe (110), eine Überwachungsstufe (150) und eine Benutzeroberfläche (170);
wobei die Leistungsstufe (110) Folgendes umfasst:

- eine Primärseite (112) mit einem primären Elektrolytkondensator (116);
- eine Sekundärseite (132) mit einem sekundären Elektrolytkondensator (136);
- ein galvanisches Trennungselement (130), das angeordnet ist, um eine galvanische Trennung zwischen der Primärseite (112) und der Sekundärseite (132) bereitzustellen;

- eine Gleichrichterstufe (134), die angeordnet ist, um eine gleichgerichtete elektrische Energie von dem galvanischen Trennungselement (130) an den sekundären Elektrolytkondensator (136) bereitzustellen;
- einen primären Temperatursensor (118) und einen sekundären Temperatursensor (138), die jeweils angeordnet sind, um Temperaturen des primären Elektrolytkondensators (116) und des sekundären Elektrolytkondensators (136) zu erfassen;
- einen Spannungssensor (140), der angeordnet ist, um eine Eingangsspannung, die an der Primärseite anliegt, zu erfassen;
- ein Stromerfassungselement (142, 144), das angeordnet ist, um einen Ausgangsstrom von der Sekundärseite zu erfassen;
- wobei die Überwachungsstufe (150) Folgendes umfasst:
- A/D-Wandlungsmittel (152), die angeordnet sind, um Informationen von jedem primären Temperatursensor (118), sekundären Temperatursensor (138), Spannungssensor (140) und Stromerfassungselement (142, 144) zu empfangen;
- Logikmittel (154-162), die angeordnet sind, um einen Satz vorbestimmter Berechnungen der Informationen, die durch die A/D-Wandlungsmittel (152) empfangen werden, durchzuführen, sodass der Satz vorbestimmter Berechnungen eine geschätzte Lebensdauer, eine geschätzte Alterungsrate und eine geschätzte Strombelastungshöhe für die Stromversorgung (100) liefert, wobei die Logikmittel ferner einen Betriebsstatistik-Speicher (162) umfassen, um Verlaufsdaten basierend auf Ergebnissen der vorbestimmten Berechnungen zu speichern;
- Darstellungsmittel (164), um die geschätzte Lebensdauer, geschätzte Alterungsrate und geschätzte Strombelastungshöhe in jeweilige Formate umzuwandeln, die über die Benutzeroberfläche (170) dargestellt werden können;
- und wobei die Benutzeroberfläche (170) Folgendes umfasst:
- Anzeigemittel (172), die auf die Darstellungsmittel (164) reagieren, um eine erste Anzeige (174) der geschätzten Alterungsrate, eine zweite Anzeige (176) der geschätzten Lebensdauer und eine dritte Anzeige (178) der geschätzten Belastungshöhe darzustellen.

2. Stromversorgung (100) nach Anspruch 1, wobei die Logikmittel (154-162) Folgendes umfassen:

- Mittel zum Speichern eines Stromwerts der geschätzten Lebensdauer;
- Mittel zum Verringern des Stromwerts der geschätzten Lebensdauer, basierend auf den Informationen von dem primären Temperatursensor (118), sekundären Temperatursensor (138), dem Spannungssensor (140) und dem Stromerfassungselement (142, 144)
- Mittel zum Aktualisieren des gespeicherten Stromwerts der geschätzten Lebensdauer basierend auf dem verringerten Stromwert der geschätzten Lebensdauer.

3. Stromversorgung (100) nach Anspruch 1, wobei die erste Anzeige (174) der geschätzten Alterungsrate eine visuelle Anzeige ist und das Format der geschätzten Alterungsrate, wie durch die Darstellungsmittel (164) bereitgestellt, eine Blinkrate umfasst, die kontinuierlich oder schrittweise proportional zu der geschätzten Alterungsrate ist.

4. Stromversorgung (100) nach Anspruch 3, wobei das Format für die geschätzte Alterungsrate, wie durch die Darstellungsmittel (164) bereitgestellt, ferner mindestens eine Farbveränderung umfasst, wenn die geschätzte Alterungsrate einen vorbestimmten Schwellenwert überschreitet.

5. Stromversorgung nach einem der vorhergehenden Ansprüche, wobei:

- mindestens ein Temperatursensor (118, 138, 420, 420') an einer Leiterplatte (420, 420') an der Seite gegenüber seinem jeweiligen Elektrolytkondensator (418) montiert ist und der Bereich der Leiterplatte unmittelbar gegenüber dem Temperatursensor durch ein Wärmeleitungselement an eine Oberflächentemperatur des Elektrolytkondensators thermisch gekoppelt ist; und
- die Stromversorgung Mittel umfasst, um die Temperatur, die über den Temperatursensor erfasst wird, in eine Innentemperatur des Elektrolytkondensators umzuwandeln.

**Revendications**

1. Alimentation (100) comprenant un étage d'alimentation (110), un étage de surveillance (150) et une interface d'utilisateur (170) ;
où l'étage d'alimentation (110) comprend :

- un côté primaire (112) avec un condensateur électrolytique primaire (116) ;
- un côté secondaire (132) avec un condensateur électrolytique secondaire (136) ;
- un élément d'isolation galvanique (130), agencé pour procurer une isolation galvanique entre le côté primaire (112) et le côté secondaire (132) ;
- un étage rectifieur (134), agencé pour procurer une énergie électrique rectifiée à partir de l'élément d'isolation galvanique (130) au condensateur électrolytique secondaire (136) ;
- un capteur de température primaire (118) et un capteur de température secondaire (138), respectivement agencés pour détecter les températures du condensateur électrolytique primaire (116) et du condensateur électrolytique secondaire (136) ;
- un capteur de tension (140), agencé pour détecter une tension d'entrée présente au niveau du côté primaire ;
- un élément de détection de courant (142, 144), agencé pour détecter un courant d'entrée à partir du côté secondaire ;
- où l'étage de surveillance (150) comprend :
- des moyens de conversion A/C (152), agencés pour recevoir des informations provenant de chaque capteur parmi le capteur de température primaire (118), le capteur de température secondaire (138), le capteur de tension (140) et l'élément de détection de courant (142, 144) ;
- des moyens logiques (154 à 162), agencés pour effectuer un ensemble de calculs prédéterminés sur les informations reçues par les moyens de conversion A/C (152), de sorte que l'ensemble des calculs prédéterminés donne une estimation de la durée de vie, une estimation du taux de vieillissement et une estimation du niveau de charge de courant pour l'alimentation (100), où les moyens logiques comprennent en outre une mémoire de statistiques de fonctionnement (162) pour le stockage de l'historique des données basé sur des résultats des calculs prédéterminés ;
- des moyens de présentation (164) pour la conversion de l'estimation de la durée de vie, de l'estimation du taux de viellissement et de l'estimation du niveau de charge de courant à des formats présentables via l'interface d'utilisateur (170) ;
- et où l'interface d'utilisateur (170) comprend :
- des moyens indicateurs (172), sensibles aux moyens de présentation (164) pour la présentation d'une première indication (174) de l'estimation du taux de vieillissement, une deuxième indication (176) de l'estimation de la durée de vie et une troisième indication (178) de l'estimation du niveau de charge.

2. Alimentation (100) selon la revendication 1, dans laquelle les moyens logiques (154 à 162) comprennent :

- des moyens pour le stockage d'une valeur en cours de l'estimation de la durée de vie ;
- des moyens pour la réduction de la valeur en cours de l'estimation de la durée de vie sur la base de l'information provenant du capteur de température primaire (118), du capteur de température secondaire (138), du capteur de tension (140) et de l'élément de capture du courant (142, 144) ;
- des moyens pour la mise à jour de la valeur en cours stockée de l'estimation de la durée de vie sur la base d'une valeur de courant réduite de l'estimation de la durée de vie.

3. Alimentation (100) selon la revendication 1, dans laquelle la première indication (174) de l'estimation du taux de viellissement est une indication visuelle et le format pour l'estimation du taux de viellissement, tel que fourni par les moyens de présentation (164) comprend un taux clignotant qui est continuellement ou par étape proportionnel à l'estimation du taux de vieillissement.

4. Alimentation (100) selon la revendication 3, dans laquelle le format pour l'estimation du taux de vieillissement, tel que fourni par les moyens de présentation (164) comprend en outre au moins une variation d'une couleur lorsque l'estimation du taux de vieillissement passe un seuil prédéterminé.

5. Alimentation selon l'une quelconque des revendications précédentes, dans laquelle :

- au moins un capteur de température (118, 138, 420, 420') est monté sur un circuit imprimé (420, 420') sur le côté opposé à son condensateur électrolytique respectif (418), et la zone du circuit imprimé médiatement à l'opposé du capteur de température est couplée thermiquement à une température de surface du condensateur électrolytique par un élément de conduction thermique ; et
- l'alimentation comprend des moyens pour la conversion de la température détectée via le capteur de température en une température interne du condensateur électrolytique.

# Fig. 1

Fig. 2

170

172

204 — Aging rate ~ 174

206 — Lifetime ~ 176

208 — Stress ~ 178

180

212 →

214 →

Fig. 3

300

314   312

History data interval selection
☐ 1h
☐ 24h
☐ 30d
☐ 1y
☐ all

320

History data type selection
☐ Primary overvoltage 5%
☐ Primary overvoltage 10%
☐ Internal over temperature 10C
☐ Internal over temperature 20C
☐ Power boost cases
☐ Power boost cases without dip
☐ Operating hours
☐ Remaining hours based on use history

330

Fig. 4A

Fig. 4B

**REFERENCES CITED IN THE DESCRIPTION**

**Patent documents cited in the description**

- JP 2009195044 A
- US 6880967 B2
- US 2009072982 A1